# FASCICULE DE BREVET EUROPEEN

(11) **EP 2 801 113 B1**
(45) Date de publication et mention de la délivrance du brevet: **30.03.2016**
(21) Numéro de dépôt: 13701815.6
(22) Date de dépôt: 03.01.2013
(51) Int. Cl.: H01L 29/786, H01L 21/02, C30B 29/08, H01L 31/18, H01L 31/077, H01L 31/075, H01L 31/0352, H01L 29/24, H01L 29/161, H01L 29/16, H01L 29/06

(54) **PROCÉDÉ DE PRODUCTION À BASSE TEMPÉRATURE DE NANOSTRUCTURES SEMI-CONDUCTRICES À JONCTION RADIALE, DISPOSITIF A JONCTION RADIALE ET CELLULE SOLAIRE COMPRENANT DES NANOSTRUCTURES À JONCTION RADIALE**
VERFAHREN ZUR TIEFTEMPERATURHERSTELLUNG VON HALBLEITERNANOSTRUKTUREN MIT RADIALÜBERGÄNGEN, RADIALÜBERGANGSVORRICHTUNG UND SOLARZELLE MIT NANOSTRUKTUREN MIT RADIALÜBERGÄNGEN
METHOD FOR THE LOW-TEMPERATURE PRODUCTION OF RADIAL-JUNCTION SEMICONDUCTOR NANOSTRUCTURES, RADIAL JUNCTION DEVICE, AND SOLAR CELL INCLUDING RADIAL-JUNCTION NANOSTRUCTURES

(30) Priorité: 04.01.2012 FR 1250085
(43) Date de publication de la demande: 12.11.2014
(73) Titulaire: TOTAL MARKETING SERVICES, 92800 Puteaux (FR); Centre National de la Recherche Scientifique (CNRS), 75016 Paris (FR); Ecole Polytechnique, 91120 Palaiseau (FR)
(72) Inventeur: YU, Linwei, F-91120 Palaiseau (FR); ROCA I CABARROCAS, Pere, F-91140 Villebon Sur Yvette (FR)
(74) Mandataire: Coralis Harle
(86) Numéro de dépôt international: PCT/FR2013/050005
(87) Numéro de publication internationale: WO 2013/102731

(56) Documents cités:
- EP-A1- 1 936 666
- FR-A1- 2 928 939
- LINWEI YU ET AL: "Plasma-enhanced low temperature growth of silicon nanowires and hierarchical structures by using tin and indium catalysts", NANOTECHNOLOGY, IOP, BRISTOL, GB, vol. 20, no. 22, 3 juin 2009 (2009-06-03), page 225604, XP020160542, ISSN: 0957-4484
- YU L ET AL: "All-in-situ fabrication and characterization of silicon nanowires on TCO/glass substrates for photovoltaic application", SOLAR ENERGY MATERIALS AND SOLAR CELLS, ELSEVIER SCIENCE PUBLISHERS, AMSTERDAM, NL, vol. 94, no. 11, 1 novembre 2010 (2010-11-01), pages 1855-1859, XP027307642, ISSN: 0927-0248 [extrait le 2010-09-22]
- LINWEI YU ET AL: "Synthesis, morphology and compositional evolution of silicon nanowires directly grown on SnO2 substrates", NANOTECHNOLOGY, IOP, BRISTOL, GB, vol. 19, no. 48, 3 décembre 2008 (2008-12-03), page 485605, XP020144908, ISSN: 0957-4484, DOI: 10.1088/0957-4484/19/48/485605
- LINWEI YU ET AL: "Radial junction amorphous silicon solar cells on PECVD-grown silicon nanowires", 27 avril 2012 (2012-04-27), NANOTECHNOLOGY, IOP, BRISTOL, GB, PAGE(S) 194011, XP020222443, ISSN: 0957-4484 le document en entier

## Description

La présente invention se rapporte généralement à la fabrication de structures électroniques à jonction radiale (par exemple de type n-i-p, p-i-n, n-p, p-n ou de cellules tandem) formées à partir d'un réseau de nanofils semi-conducteurs. L'invention trouve notamment des applications dans la fabrication de cellules solaires photovoltaïques à bas coût.

L'énergie solaire est la source d'énergie renouvelable la plus abondante pour supporter un développement durable de la société humaine. Il est essentiel de promouvoir les technologies d'énergie photovoltaïques pour réduire les émissions de gaz à effet de serre. Toutefois, il est aussi critique pour les technologies photovoltaïques d'atteindre la parité en termes de coût par watt par rapport à une grille tarifaire d'électricité conventionnelle.

La première génération de cellules solaires, qui était basée sur l'utilisation de tranches de silicium cristallin, a dominé le marché photovoltaïque depuis son introduction, il y a une cinquantaine d'années. La structure de bandes du silicium cristallin le rend peu efficace en termes d'absorption lumineuse ce qui requiert une épaisseur de silicium cristallin de 100 à 300 microns. De plus, la taille des cellules solaires est limitée par la taille des tranches de silicium cristallin. Ceci conduit à un coût élevé de matériaux pour les cellules solaires à base de silicium cristallin. Dans le but de réduire le coût par watt, la deuxième génération de cellules solaires a adopté la technologie de dépôt de couches minces de silicium polycristallin ou de silicium amorphe. La technologie de cellules solaires en couches minces est de faible coût et peut être adaptée aisément à des tailles de supports différentes (jusqu'à 6 m² sur verre et sur des rouleaux de plus de 1 Km de long). Dans une cellule solaire en couches minces, on dépose un empilement de couches ayant des dopages différents pour produire une jonction par exemple de type p-i-n ou n-i-p entre deux électrodes en couches minces. Les électrodes servent à collecter le courant de porteurs photo-générés. L'absorption lumineuse est d'autant plus importante que l'épaisseur de silicium amorphe ou polycristallin est grande. Cependant, du fait de la faible longueur de diffusion des porteurs photo-générés, la distance inter-électrodes doit être limitée. Un compromis doit donc être recherché dans une cellule solaire planaire en couches minces entre d'une part une épaisseur grande pour assurer un niveau suffisant d'absorption lumineuse dans le matériau et d'autre part une longueur de diffusion assez grande par rapport à l'épaisseur de la cellule pour permettre de collecter la plupart des porteurs photo-générés. A noter que plus que la diffusion, c'est le champ électrique généré par les couches dopées qui permet la séparation des paires électron-trou. La performance des cellules solaires en couches minces se trouve en général limitée par les mauvaises propriétés électriques du silicium amorphe ou microcristallin.

D'autres types de jonctions électroniques pour cellules solaires que les jonctions planaires en couches minces ont été développés. Une jonction électronique ayant un design de type jonction radiale p-i-n a récemment été proposé pour dépasser ces limites et inconvénients. Ce nouveau design de jonction radiale consiste tout d'abord à fabriquer un réseau de nanofils servant de support physique à une jonction électronique p-i-n obtenue par dépôt d'une couche semiconductrice dopée p, puis d'une couche semiconductrice intrinsèque (i) et enfin d'une couche semiconductrice dopée n. On réalise ainsi une jonction radiale p-i-n à structure en 3D, par dessus un réseau de nanofils. La forêt de nanofils présente un piégeage de la lumière omnidirectionnel et permet une absorption sur un large domaine de longueurs d'ondes du spectre visible et proche infrarouge. Une structure à jonction radiale permet de découpler la longueur d'absorption lumineuse de la distance de séparation des porteurs.

La faisabilité de cellules solaires à jonction radiale a premièrement été vérifiée sur un seul nanofil de silicium (Tian, Zheng et al 2007) ou sur un nanofil de semi-conducteur de type III-V (Thunich, Prechtel et al. 2009). Des cellules solaires à jonction radiale ont aussi été réalisées par-dessus un réseau de nanofils de silicium ordonnés ou aléatoirement verticaux (Tsakalakos, Balch et al. 2007 ; Yu, O'Donnell et al. 2010). Les réseaux de nanofils de silicium qui conviennent à cette application peuvent être obtenus, soit par des techniques de gravure top-down dans du silicium cristallin (Garnett and Yang 2010 ; Lu and Lal 2010) ou par une technique de croissance bottom-up par exemple la technique vapeur-liquide-solide (VLS) (Schmid, Bjork et al. 2008 ; Yuan, Zhao et al. 2009 ; Schmidt, Wittemann et al. 2010).

L'approche VLS consiste à utiliser des gouttes de catalyseur en phase liquide pour catalyser la croissance de nanofils à partir de précurseurs en phase gazeuse et faire croître des structures solides à une dimension telles que des nanofils. La technique VLS améliore le procédé de fabrication de nanofils selon plusieurs aspects. Le procédé de fabrication de nanofils par VLS est mieux contrôlable. Le procédé VLS permet une mise à l'échelle sur des substrats de grandes dimensions, avec un fort rendement. Enfin le procédé VLS est également compatible avec une température de croissance faible et s'applique à de nombreux substrats à faible coût. Toutefois, les performances d'une cellule solaire à jonction radiale réalisée par la technique VLS sur nanofils de silicium sont encore assez limitées, l'efficacité étant actuellement de l'ordre 0.1 à 2 % (Tsakalakos, Balch et al. 2007; Th, Pietsch et al. 2008 : Gunawan et Guha 2009; Perraud, Poncet et al. 2009). Cette efficacité limitée témoigne du fait que le transfert de connaissances établies pour le silicium cristallin planaire ou pour les cellules en couches minces vers une structure radiale en 3D n'est pas une tâche triviale. Le design optique d'une jonction radiale p-i-n est jusqu'à présent réalisé par-dessus un réseau de nanofils de silicium. Cette nouvelle structure introduit des aspects complètement nouveaux dans le design et la fabrication de cellules solaires de haute performance dans une architecture en 3D. Aujourd'hui, on fabrique des cellules à jonction radiale dont le rendement atteint 5-6%.

La croissance de nanofils de silicium par procédé VLS repose le plus communément sur l'utilisation de l'or en tant que catalyseur métallique. Cependant, le point de fusion de l'or (Tf = 1064°C) nécessite une température de substrat élevée. De plus, l'or a pour inconvénient majeur d'introduire des défauts électroniques à des niveaux profonds en milieu de bande interdite du silicium. La contamination induite par l'or ainsi que son coût très élevé expliquent qu'une étape de récupération de l'or résiduel soit mise en oeuvre entre l'étape de croissance VLS et l'étape de dépôt d'un empilement de couches minces. La croissance de nanofils de silicium par procédé VLS a déjà été réalisée en utilisant comme catalyseur métallique de l'indium, de l'étain ou du gallium (Alet, Yu et al 2008; Yu Alet et al. 2008, Yu ODonnell et al 2009). L'utilisation d'un catalyseur métallique tel que l'étain, ayant un faible point de fusion, permet la croissance de nanofils de silicium à des températures inférieures à 200°C (Yu, Alet et al. 2008 ; Yu, O'Donnell et al. 2009). Qui plus est, l'étain n'introduit pas de défauts électroniques au milieu de la bande interdite du silicium, comme c'est le cas pour l'Au.

D'autre part, le dopage d'une jonction électronique (p-n, n-p, p-i-n ou n-i-p) réalisée par dépôt chimique en phase vapeur repose généralement sur l'utilisation de plusieurs gaz dopants pendant le procédé de dépôt chimique en phase vapeur. C'est pour exemple le cas dans FR 2928939. La fabrication d'une jonction électronique nécessite couramment l'utilisation d'au moins deux gaz dopants, un premier gaz dopant pour le dopage de type n et un autre gaz dopant pour le dopage de type p. Or, l'utilisation de plusieurs gaz dopants introduit des problèmes compliqués pour le nettoyage de la chambre de dépôt de manière à éviter les contaminations croisées entre les différentes couches déposées. Les gaz dopants recouvrent en effet les murs intérieurs de la chambre de dépôt et sont recyclés pendant l'étape suivante de dépôt d'une couche de dopage différent. Dans le cas d'une jonction de type p-i-n ou n-i-p, il est très difficile d'éviter une contamination de la couche intrinsèque par le dopant p ou n de la couche sous-jacente à la couche intrinsèque déposée dans le même réacteur de dépôt. D'autre part, les gaz dopants tels que B₂H₆ ou PH₃ sont des gaz toxiques.

Un des buts de l'invention est de simplifier le procédé de fabrication d'une cellule solaire. Un autre but de l'invention est de réduire la contamination de la couche intrinsèque d'une jonction p-i-n ou n-i-p par les dopants utilisés dans le réacteur ou par le dopant d'une couche sous jacente. En particulier, il est essentiel d'éviter la création de centres de piégeage électronique au centre de la bande interdite du matériau semi-conducteur. II, est également crucial d'éviter la contamination croisée des couches dopées n et p d'une jonction électronique. Un autre but de l'invention est de limiter l'utilisation de gaz dopants toxiques tels que B₂H₆ ou PH₃.

La présente invention a pour but de remédier aux inconvénients des techniques antérieures et concerne plus particulièrement un procédé de production à basse température d'au moins une nanostructure semi-conductrice à jonction électronique radiale sur un substrat comprenant les étapes suivantes:
a) formation d'agrégats métalliques sur ledit substrat, lesdits agrégats niétalliques dopant électroniquement un premier matériau semi-conducteur avec un premier type de dopage,
b) croissance en phase vapeur de nanofils semi-conducteurs dopés en ledit premier matériau semi-conducteur sur ledit substrat recouvert d'agrégats métalliques, ledit substrat étant chauffé à une température supérieure ou égale à la température eutectique desdits agrégats métalliques, la croissance en phase vapeur de nanofils semi-conducteurs dopés étant catalysée par lesdits agrégats métalliques en présence d'un ou plusieurs gaz précurseurs dudit premier matériau semi-conducteur, lesdites un ou plusieurs gaz précurseurs étant non dopants,
c) inactivation des agrégats métalliques résiduels,
d) dépôt chimique en phase vapeur en présence d'un ou plusieurs gaz précurseurs et d'un gaz dopant d'au moins une couche mince d'un second matériau semi-conducteur sur lesdits nanofils semi-conducteurs dopés, ledit gaz dopant étant apte à doper électroniquement ledit second matériau semi-conducteur avec un second type de dopage, et ladite au moins une couche mince d'un second matériau semi-conducteur étant déposée de manière conforme sur lesdits nanofils semi-conducteurs dopés pour former au moins une nanostructure à jonction électronique radiale entre ledit nanofil semi-conducteur dopé avec un premier type de dopage et ladite au moins une couche mince dopée avec un second type de dopage,
   - lesdites étapes a) de formation d'agrégats métalliques, b) de croissance de nanofils semi-conducteurs dopés, c) d'inactivation des agrégats métalliques et d) de dépôt chimique en phase vapeur étant réalisées successivement dans une même enceinte de dépôt sous vide.

Selon un mode de réalisation préféré, le procédé de production d'au moins une nanostructure semi-conductrice à jonction électronique radiale comprend une étape intermédiaire entre l'étape c) d'inactivation des agrégats métalliques résiduels et l'étape d) de dépôt chimique en phase vapeur d'au moins une couche mince d'un second matériau semi-conducteur dopé, ladite étape intermédiaire comprenant une étape de dépôt chimique en phase vapeur en présence d'un ou plusieurs gaz précurseurs d'une autre couche mince d'un troisième matériau semi-conducteur non dopé (ou intrinsèque) de manière conforme sur lesdits nanofils semi-conducteurs dopés, lesdits nanofils semi-conducteurs dopés étant dopés de type -p et ladite au moins une couche mince d'un second matériau semi-conducteur étant dopée -n pour former des nanostructures semi-conductrices à jonction électronique radiale de type p-i-n, ou respectivement lesdits nanofils semi-conducteurs dopés étant dopés de type -n et ladite au moins une couche mince d'un second matériau semi-conducteur étant dopée -p pour former des nanostructures semi-conductrices à jonction électronique radiale de type n-i-p.

Selon différents aspects particuliers du procédé de l'invention :
- l'étape c) d'inactivation des agrégats métalliques résiduels comprend une étape de diminution de la température jusqu'à une température inférieure à la température eutectique desdits agrégats métalliques et/ou une étape de gravure chimique en phase vapeur et/ou une étape d'application d'un plasma réducteur d'hydrogène ;
- l'étape d) de dépôt chimique d'au moins une couche mince d'un second matériau semi-conducteur dopé comprend une étape de dépôt chimique en phase vapeur ou une étape de dépôt chimique en phase vapeur assisté par plasma, en présence d'un mélange de gaz comprenant un gaz précurseur du second matériau semi-conducteur et un gaz dopant ;
- ledit premier matériau semi-conducteur, ledit second matériau semi-conducteur et/ou ledit troisième matériau semi-conducteur sont choisis parmi du silicium, et du germanium ;
- ledit premier matériau semi-conducteur est du silicium cristallin dopé de type -p et ledit second matériau semi-conducteur est du silicium amorphe dopé de type -n, et/ou ledit troisième matériau semi-conducteur est du silicium amorphe intrinsèque ;
- l'étape a) de formation d'agrégats métalliques comprend la formation d'agrégats constitués de bismuth, de gallium ou d'un alliage d'étain et d'un matériau choisi parmi le bismuth, l'indium et le gallium, le bismuth et l'alliage de bismuth et d'étain produisant un dopage électronique de type -n dans du silicium, le gallium et l'alliage d'étain et de gallium ou d'indium produisant un dopage électronique de type -p dans du silicium.

Selon un mode de réalisation particulier, ladite couche mince d'un troisième matériau semi-conducteur, intrinsèque comporte du silicium amorphe, et ledit procédé comporte une étape supplémentaire après l'étape c) d'inactivation des agrégats métalliques résiduels et avant l'étape de dépôt de ladite couche mince de silicium amorphe intrinsèque, ladite étape supplémentaire comprenant une étape de dépôt chimique en phase vapeur en présence d'un ou plusieurs gaz précurseurs d'une couche mince amorphe d'un matériau semi-conducteur ayant le même type de dopage que les nanofils semi-conducteurs dopés de manière conforme sur lesdits nanofils semi-conducteurs dopés.

Selon d'autres aspects particuliers du procédé de l'invention :
- la température du substrat pendant les étapes a) b) c) et d) reste inférieure à 400°C;
- le substrat est un substrat métallique non texturé, en silicium cristallin ou polycristallin, en verre, en polymère ou en matériau plastique.

Selon un mode de réalisation particulier, le procédé de l'invention comprend au moins une étape supplémentaire suivante après l'étape d) :
e) dépôt d'au moins un autre empilement d'une pluralité de couches minces de matériau semi-conducteur, ledit au moins un autre empilement de couches minces étant déposé de manière conforme sur ladite au moins une nanostructure semi-conductrice à jonction électronique radiale et ladite pluralité de couches minces ayant un dopage respectif adapté pour former au moins une nanostructure semi-conductrice à double jonction électronique radiale (cellule tandem).

L'invention concerne aussi un dispositif à jonction électronique radiale comprenant un substrat, au moins un nanofil semi-conducteur dopé en un premier matériau semi-conducteur dopé avec un premier type de dopage, ledit au moins un nanofil semi-conducteur dopé s'étendant à partir dudit substra dans lequel ledit premier matériau est choisi parmi du silicium et du germanium, et dans lequel le bismuth est le dopant de type n, respectivement dans lequel le gallium est le dopant de type p, au moins une couche mince d'un second matériau semi-conducteur avec un second type de dopage, ladite au moins une couche mince d'un second matériau semi-conducteur étant déposée de manière conforme sur ledit au moins un nanofil semi-conducteur dopé pour former au moins une nanostructure semi-conductrice à jonction électronique radiale entre ledit nanofil semi-conducteur dopé et ladite au moins une couche mince d'un second matériau semi-conducteur dopé.

Selon un mode de réalisation particulier, le dispositif à jonction électronique radiale comprend en outre une autre couche mince d'un troisième matériau semi-conducteur intrinsèque déposée de manière conforme sur ledit au moins un nanofil semi-conducteur dopé et en dessous ladite au moins une couche mince d'un second matériau semi-conducteur, ledit au moins un nanofil semi-conducteur dopé étant dopé de type -p et ladite au moins une couche mince d'un second matériau semi-conducteur étant dopée -n pour former au moins une nanostructure semi-conductrice à jonction électronique radiale de type p-i-n, ou respectivement ledit au moins un nanofil semi-conducteur dopé étant dopé de type -n et ladite au moins une couche mince d'un second matériau semi-conducteur étant dopée -p pour former au moins une nanostructure semi-conductrice à jonction électronique radiale de type n-i-p.

Selon un mode de réalisation particulier, le dispositif à jonction électronique radiale comprend en outre au moins un autre empilement d'une pluralité de couches minces semi-conductrices, ledit au moins un autre empilement de couches minces étant déposé de manière conforme sur ladite au moins une nanostructure semi-conductrice à jonction électronique radiale et ladite pluralité de couches minces semi-conductrices ayant un dopage respectif adapté pour former au moins une nanostructure semi-conductrice à double jonction électronique radiale (autrement dit une cellule tandem).

Selon un mode de réalisation particulier, le dispositif à jonction électronique radiale comprend au moins un nanofil dopé de silicium.

L'invention concerne aussi une cellule solaire comprenant une pluralité de nanostructures à jonction électronique radiale selon l'un des modes de réalisation de l'invention.

L'invention trouvera une application particulièrement avantageuse dans la fabrication à bas coût de cellules solaires de grande efficacité.

La présente invention concerne également les caractéristiques qui ressortiront au cours de la description qui va suivre et qui devront être considérées isolément ou selon toutes leurs combinaisons techniquement possibles.

L'invention sera mieux comprise et d'autres buts, détails, caractéristiques et avantages de celle-ci apparaîtront plus clairement au cours de la description d'un (des) mode(s) de réalisation.particulier(s) de l'invention donné(s) uniquement à titre illustratif et non limitatif en référence aux dessins annexés. Sur ces dessins :
- la figure 1 A représente une microphotographie de nanofils de silicium obtenus par croissance VLS à partir d'un catalyseur de bismuth liquide pur ; la figure 1 B représente un agrandissement d'un nanofil de la fig. 1A ;
- la figure 2 représente une microphotographie de nanofils de silicium obtenus par croissance VLS à partir d'un catalyseur formé d'un alliage de bismuth et d'étain;
- la figure 3 représente une microphotographie de nanofils de silicium obtenus par croissance VLS à partir d'un catalyseur formé d'étain pur;
- la figure 4 représente le diagramme de phase d'un alliage de bismuth et d'étain en fonction de la proportion relative des deux éléments et en fonction de la température ;
- la figure 5 représente schématiquement les étapes de production de nanostructures à jonction électronique radiale selon un mode de réalisation de l'invention;
- la figure 6 représente schématiquement une vue éclatée d'une nanostructure à jonction électronique radiale selon un mode de réalisation de l'invention ;
- la figure 7A représente une microphotographie de nanostructures à jonction électronique radiale formées à partir de nanofils de silicium obtenus par le procédé de production de l'invention ; la figure 7B représente un agrandissement d'une nanostructure à jonction électronique radiale de la fig. 7A ; la figure 7C représente une vue en coupe d'une nanostructure à jonction électronique radiale de la fig. 7A ;
- la figure 8 représente des courbes courant-tension (ou I-V) de différentes nanostructures à jonction électronique.

Nous utilisons un procédé de fabrication de type VLS pour produire de manière simplifiée des nanostructures à jonction électronique radiale.

Plus précisément, la croissance de nanofils de silicium par catalyse métallique permet de résoudre le problème de contamination d'une couche de matériau semi-conducteur intrinsèque par le gaz dopant de la couche dopée sous-jacente, comme il est explicité plus loin.

Nous avons développé une technique spéciale pour incorporer la structure de nanofils de silicium dans une structure de cellules solaires en couches minces dans un système de dépôt par plasma de type PECVD conventionnel. L'utilisation de catalyseur tel que l'indium et l'étain ayant un faible point de fusion permet la croissance de nanofils de silicium à des températures inférieures à 200°C tout en évitant la contamination à des niveaux profonds en milieu de bande interdite qui sont créés par un catalyseur tel que l'or. L'invention utilise l'étape de croissance par catalyse métallique pour doper par catalyse *in situ* des nanofils semi-conducteurs de type n ou de type p sans utilisation de gaz dopant.

Nous utilisons différents catalyseurs métalliques pour effectuer le dopage du coeur des nanofils de semi-conducteurs, par exemple de nanofils de silicium. Par exemple, le bismuth est utilisé pour introduire un dopage de type n peu profond dans des nanofils de silicium. Le gallium ou l'indium conduisent à un dopage de type p dans des nanofils de silicium. L'incorporation de dopant pendant la croissance des nanofils semi-conducteurs peut être réalisée *in situ* pendant un procédé de croissance de nanofils de type VLS dans un dispositif conventionnel de dépôt chimique assisté par plasma (PECVD).

Afin d'éviter la diffusion de dopants dans une structure radiale de type p-n ou p-i-n, la température de dépôt est contrôlée précisément pour être la plus faible possible. La réduction de la température de dépôt est un point important pour l'incorporation de nanofils semi-conducteurs dans les procédés de dépôt de structures en couches minces à faible coût. Nous sélectionnons le bismuth ou son alliage avec l'étain pour réduire la température de croissance des nanofils semi-conducteurs.

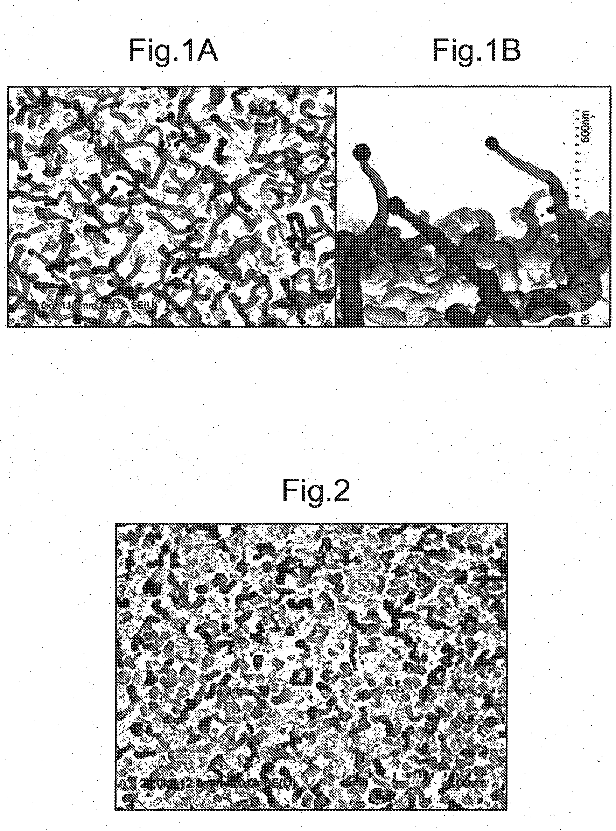

Selon un mode de réalisation préféré de l'invention, nous utilisons comme catalyseur métallique du bismuth ou un alliage de bismuth pour produire des nanofils de silicium à basse température et pour contrôler le dopage par incorporation du catalyseur métallique dans les nanofils de silicium. Le bismuth introduit un dopage de type n à un niveau peu profond, à 160mV en dessous de la bande de conduction du silicium. Les figures 1 A et 1 B représentent des nanofils de silicium produits à partir de gouttelettes de bismuth (pur) dans un procédé VLS à 350°C. La figure 1B représente un agrandissement d'un nanofil de silicium de la figure 1 A. Comme on l'observe sur les figures 1 A et 1 B, les nanofils de silicium obtenus à partir d'un catalyseur de bismuth pur présentent des courbures et des orientations relatives aléatoires. Le catalyseur peut donc aussi être utilisé pour contrôler la morphologie des nanofils de silicium.

Les nanofils ont une longueur pouvant aller de quelques dizaines de nanomètres à plusieurs centaines de nanomètres, voire plusieurs micromètres.

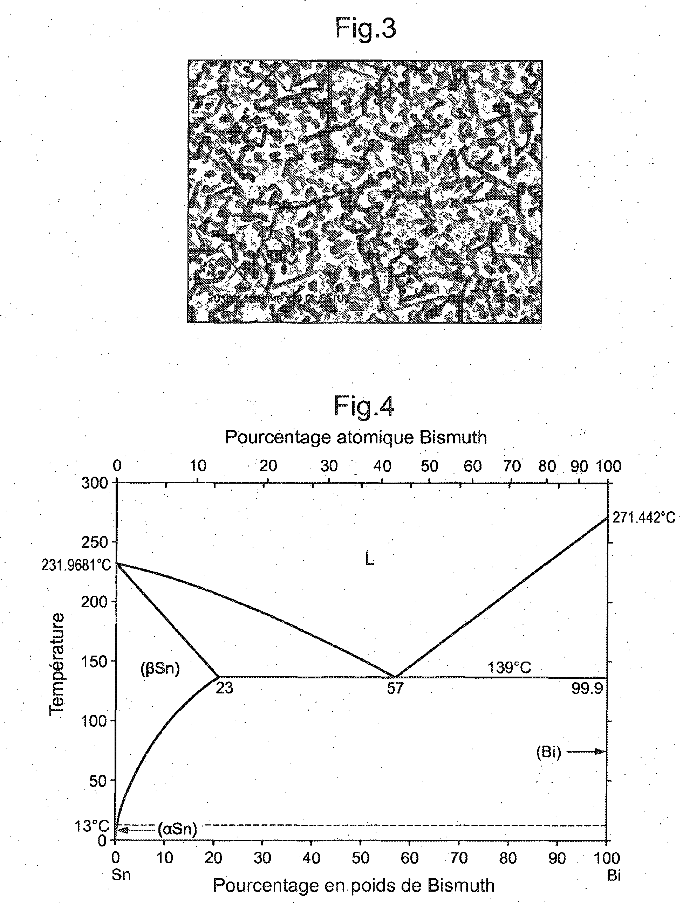

Les figures 2 et 3 représentent des nanofils de silicium obtenus par un procédé VLS à une température de 500°C. Le catalyseur métallique utilisé est un alliage de bismuth et d'étain dans le cas de la figure 2 et de l'étain pur dans le cas de la figure 3. L'addition d'étain pour former un alliage de bismuth et d'étain conduit à une morphologie de nanofils plus rectiligne comme on l'observe sur la figure 3 et à une vitesse de croissance des nanofils plus rapide à une même température. L'étain pur n'introduit pas de dopage du silicium.

Nous proposons de contrôler précisément la température de croissance des nanofils de silicium en utilisant un alliage de bismuth pour le dopage de type *n* des nanofils de silicium ou un alliage de gallium pour le dopage de type p des nanofils de silicium. Plus précisément, la température de fusion d'un alliage de bismuth (ou de gallium) et d'étain peut être réduite significativement. La figure 4 représente le diagramme de phase d'un alliage de bismuth et d'étain en fonction de la proportion relative des deux éléments. La courbe de liquidus délimite le domaine (indiqué L) sur lequel l'alliage Bi-Sn est entièrement liquide. La courbe de solidus délimite le domaine sur lequel l'alliage Bi-Sn est entièrement solide. Entre la courbe de solidus et la courbe de liquidus, l'alliage est en partie liquide et en partie solide. Sur un large domaine de composition d'un alliage de Bi-Sn, pour une proportion de Bi comprise entre 0% et 43%, la température de fusion de l'alliage reste inférieure à 232°C. Pour une concentration relative de 43% de Bi, le point eutectique est abaissé à seulement 139°C. Ceci permet de réduire de manière très significative la température de croissance de nanofils de silicium et offre des perspectives très intéressantes pour le développement des applications de nanofils de silicium.

Nous proposons aussi une méthode pour contrôler de manière effective la concentration de dopant incorporé pendant la croissance des nanofils de silicium, en utilisant un alliage de bismuth (pour le dopage de type n) ou de gallium (pour le dopage de type p). En effet, l'étain n'introduit pas de dopage dans des nanofils de silicium. Combiné aux autres paramètres de croissance (notamment la température), le contrôle de la concentration en bismuth ou respectivement en gallium dans un alliage avec l'étain est une manière efficace de contrôler l'incorporation de dopant Bi ou Ga dans les nanofils de silicium. Cette approche permet aussi de contrôler la morphologie des nanofils de silicium.

Basé sur des nanofils de silicium par un procédé de type VLS utilisant un catalyseur métallique comprenant du bismuth, nous avons réalisé une cellule solaire à structure de jonction électronique radiale.

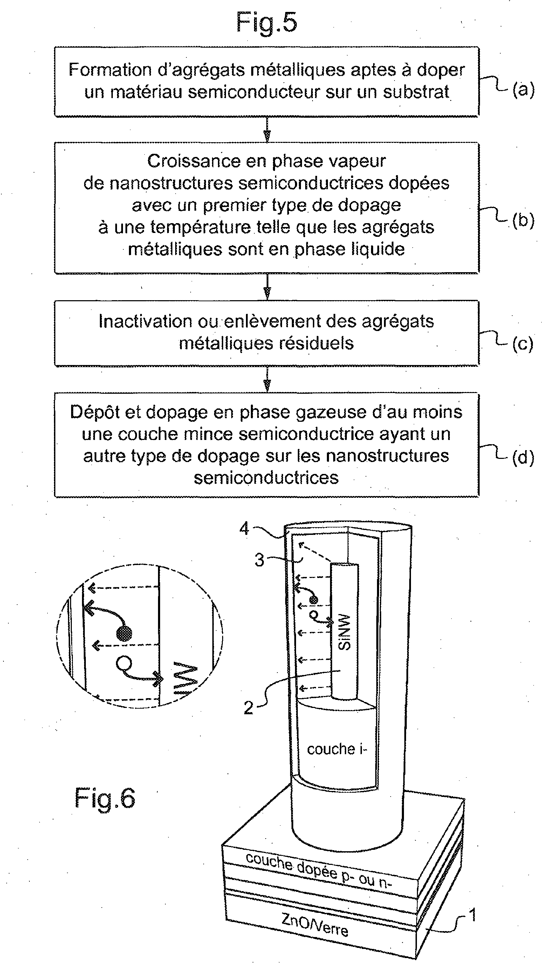

La figure 5 représente schématiquement les étapes d'un procédé de fabrication de nanostructures à jonction électronique radiale selon un mode de réalisation de l'invention.

Selon un mode de réalisation, on fait croître des nanofils de silicium à partir de nanogouttes de catalyseur métallique à base de bismuth pur - étapes a) et b). Un prétraitement du substrat (constitué d'une plaque de verre recouverte d'une couche de ∼1 µm de ZnO dopé Al et d'une fine couche de bismuth) par un plasma d'hydrogène permet de nettoyer la surface oxydée du Bi pendant le transfert du substrat dans le réacteur de PECVD. Un plasma d'hydrogène appliqué sur le Bi permet d'enlever une couche d'oxyde résiduel en surface, qui rendrait le bismuth inactif. Le plasma d'hydrogène permet aussi de transformer le film de bismuth ou d'alliage métallique en nanogouttes. On effectue la croissance des nanofils en présence des nanogouttes de catalyseur métallique et de gaz précurseur, le substrat étant à une température à laquelle le catalyseur est à l'état liquide. Dans le cas où le catalyseur est du bismuth pur, la température de croissance est par exemple de 275°C (supérieure au point de fusion du bismuth pur à 271.33°C, *cf.* figure 4). Dans le cas où le catalyseur est un alliage, le substrat est chauffé à une température supérieure ou égale à la température de liquéfaction de l'alliage, c'est-à-dire à une température située au-dessus de la courbe de liquidus sur le diagramme de phase de l'alliage considéré. On obtient ainsi un substrat recouvert de nanofils de silicium dopé n. Les nanofils de silicium ont une longueur d'environ 0.5 à 10 microns. Ensuite, on réduit la température du substrat à une valeur inférieure à la température de solidification du catalyseur, par exemple de 180°C où le bismuth pur est solide et inactif en tant que catalyseur (étape c du procédé de la Figure 5). Dans le cas où le catalyseur est un alliage, la température est alors réduite pour passer en-dessous de la courbe de solidus sur le diagramme de phase de l'alliage considéré. On effectue, à cette température de 180°C et dans la même chambre de dépôt, un dépôt d'une couche mince de silicium amorphe intrinsèque pour recouvrir de manière conforme les nanofils de silicium (étape e) non représentée sur la figure 5). Par exemple, on dépose une couche de silicium intrinsèque par dépôt plasma en présence d'un mélange d'un gaz précurseur (du silane) et d'hydrogène, pour former une couche de silicium amorphe hydrogéné non dopé. Il est important que l'épaisseur de la couche de silicium intrinsèque soit uniforme pour optimiser les performances courant tension de la structure à jonction radiale. Enfin, on effectue le dépôt d'une couche mince de silicium amorphe hydrogéné dopé p+ toujours dans la même chambre de dépôt à partie d'un mélange de gaz précurseur (du silane par exemple) et d'un gaz dopant de type *p* (par exemple du triméthylbore ou TMB moins toxique que B₂H₆) (étape d du procédé de la Figure 5). On obtient ainsi une nanostructure à jonction radiale complète de type p-i-n. On observe qu'un seul gaz dopant est utilisé pour réaliser cette nanostructure à jonction radiale, le dopage du coeur des nanofils provenant uniquement du catalyseur métallique. L'utilisation d'un seul gaz dopant, permet de sélectionner un gaz dopant tel que le TMB qui est classé comme un gaz beaucoup moins dangereux que les gaz dopants tels que le diborane et la phosphine (PH₃), ce qui permet une sécurité accrue du procédé de fabrication.

Avantageusement, les nanofils de silicium dopés n au coeur de la jonction radiale sont en silicium cristallin. Il est aisé d'obtenir une croissance de nanofils à base de silicium microcristallin à une température inférieure à 200°C et de continuer la croissance avec une couche dopé p microcristalline (formant une jonction radiale nip dans laquelle l'absorbeur est du silicium microcristallin).

Selon un mode de réalisation particulier, dans le cas où la couche intrinsèque est à base de silicium amorphe, le procédé comporte une étape supplémentaire de formation d'une couche amorphe dite couche buffer, déposée sur le nanofils avant le dépôt de la couche de silicium intrinsèque, la couche buffer ayant le même type de dopage que le nanofil. Cette couche buffer à grand gap et de même type de dopage que le nanofil cristallin permet de réduire la recombinaison de paires électron-trou à l'interface entre le nanofil et la couche intrinsèque et donc augmenter le rendement de la cellule.

Selon un autre aspect particulier, on peut compléter avec le dépôt dans le même réacteur d'une deuxième couche dopée n amorphe, une couche i amorphe et une couche p amorphe, obtenant ainsi une cellule tandem NIP/NIP.

Une autre manière pour rendre le catalyseur inactif après l'achèvement de la croissance des nanofils de silicium dopé n, est de graver le catalyseur restant en rappliquant un plasma d'hydrogène dans le même réacteur que celui où est réalisée la croissance des nanofils de silicium et le dépôt de couches minces formant la jonction radiale. Dans ce cas, la durée d'application du plasma de gravure est limitée afin d'éviter de réduire les dimensions des nanofils ou de les graver complètement. Dans un autre mode de réalisation, le catalyseur peut avoir été complètement consommé à la fin de l'étape de croissance des nanofils, auquel cas il n'est pas nécessaire d'inactiver le catalyseur avant de passer à l'étape de dépôt de couche mince conforme sur les nanofils semiconducteurs dopés.

Le procédé de fabrication de l'invention est réalisé entièrement dans une seule chambre de dépôt, à une température comprise entre 200°C et 400°C.

L'avantage du catalyseur métallique utilisé, à base de bismuth ou d'un alliage d'étain et de bismuth, est qu'il est possible de le rendre inactif ou de l'enlever dans le même réacteur de croissance des nanofils et de dépôt des couches minces. Il n'est pas nécessaire d'ouvrir la chambre de dépôt sous vide, de retirer l'échantillon ni de la transférer dans une autre chambre pour retirer le catalyseur à la fin de la croissance des nanofils. Par comparaison, dans les procédés VLS où l'or est utilisé comme catalyseur, il est nécessaire de retirer tout l'or restant à la fin de la croissance des nanofils pour éviter une contamination de la couche intrinsèque.

La figure 6 représente schématiquement une nanostructure à jonction radiale obtenue selon le mode de réalisation préféré de l'invention. Le substrat 1 est par exemple un substrat à faible coût, tel qu'un substrat de verre recouvert d'une couche de ZnO. Le coeur du nanofil 2 est dopé n ; le nanofil 2 est recouvert de manière conforme par une couche mince 3 de silicium intrinsèque puis d'une couche mince 4 de silicium dopé p. La couche mince 3 de silicium intrinsèque est utilisée pour l'absorption de lumière solaire par exemple. Le nanofil 2 dopé n et la couche mince dopée p qui forment la jonction radiale sont très proches et produisent une séparation accrue des porteurs, grâce au champ électrique interne élevé.

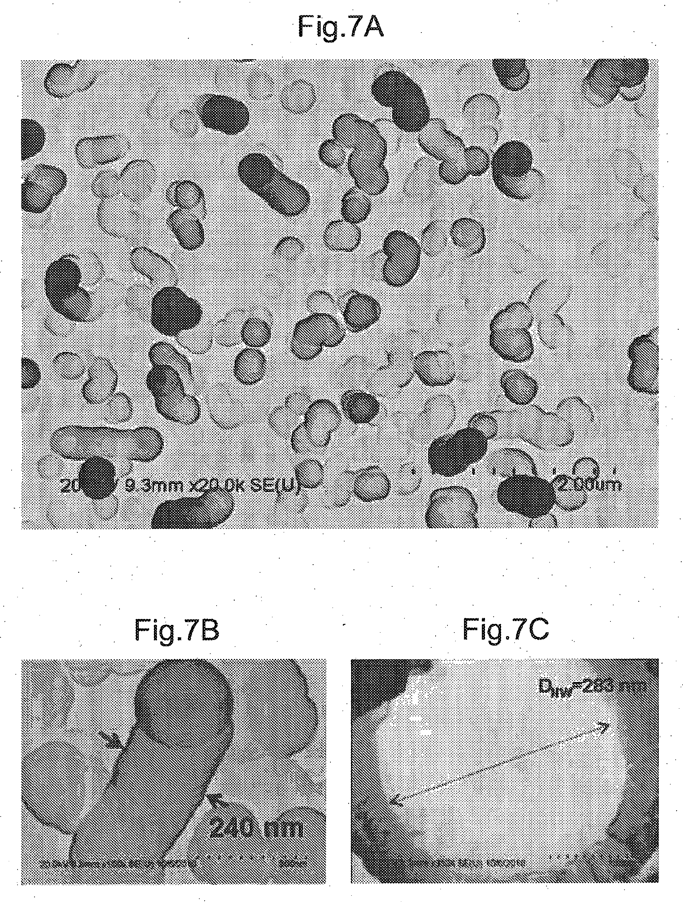

Les figures 7A, 7B et 7C représentent des vues au microscope de nanostructures à jonction radiale obtenues selon un mode de réalisation de l'invention. Les nanostructures à jonction radiale forment une forêt de jonctions radiales élémentaires, qui améliore le piégeage de la lumière. L'épaisseur totale de la structure à jonction radiale reste cependant inférieure à 200nm. Pour des nanostructures à jonction radiale selon l'invention, ayant une épaisseur de 20nm et présentant une densité de courant de 11-13mA/cm², la durée de fabrication est réduite à environ 20 minutes. Pour comparaison, la durée de fabrication de cellules solaires microcristallines ayant une épaisseur de l'ordre de 2 microns, est d'environ 2 heures. Le coût de fabrication de structure à jonction radiale en nanofils de silicium est par conséquent beaucoup plus faible que celui de jonction planaire de silicium polycristallin.

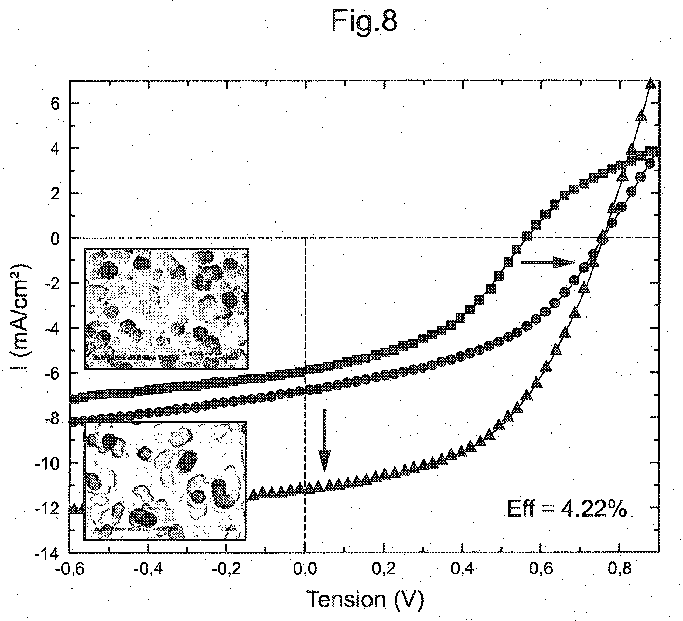

La figure 8 représente des courbes courant-tension (ou I-V) de différentes jonctions électroniques et en particulier de nanostructures à jonction radiales obtenues selon deux modes de réalisation de l'invention. La courbe représentée par des carrés correspond à un échantillon de référence, c'est-à-dire une jonction p-i-n de type planaire sans nanofils de silicium dopés au bismuth. La courbe représentée par des ronds correspond à un échantillon de nanostructures à jonction radiale p-i-n à partir de nanofils de silicium dopés au bismuth, dans laquelle les nanofils ont une longueur d'environ 0,5 µm. La courbe représentée par des triangles correspond à un échantillon de nanostructures à jonction radiale p-i-n à partir de nanofils de silicium dopés au bismuth, dans laquelle les nanofils ont une longueur d'environ 1 µm. On observe sur les courbes I-V de la figure 8, que l'utilisation du bismuth comme catalyseur-dopant et donc de nanofils de silicium dopés, augmente la valeur de la tension Voc de 0.54 V à 0.72 V. De plus, on observe clairement une augmentation du courant de court circuit, en utilisant des nanofils longs plutôt que des nanofils courts. Les nanofils longs permettent un meilleur effet de piégeage de la lumière, le courant électrique augmentant de 6mA/cm² à 8mA/cm² pour les nanofils courts (lié à un piégeage de lumière limité) et à 12mA/cm² pour les nanofils longs (lié à un fort piégeage de lumière). Ceci confirme la faisabilité de la fabrication de cellules solaires à structure de jonction radiale à partir de nanofils de silicium utilisant le bismuth comme catalyseur. Les courbes I-V confirment aussi, de part leur Voc, le dopage effectif de type n induit par le catalyseur métallique dans les nanofil de silicium, ce dopage effectif produisant une augmentation de la tension Voc en l'absence de tout gaz dopant de type n dans le réacteur de dépôt.

Un des buts de l'invention est de réaliser une cellule solaire ayant une efficacité de 10-12% pour une jonction simple et de 14% pour une jonction tandem. La texture optimale obtenue avec les nanofils de silicium dopé permet d'éviter de recourir à un procédé pour texturer la surface d'un substrat de verre ou de ZnO, qui implique un coût supplémentaire.

Le procédé de fabrication de nanostructures à jonction radiale étant effectué à basse température. Avantageusement, la température du substrat reste inférieure à une température de 350 à 400 degrés compatible avec le dépôt de couches minces par PECVD. Dans le cas où le catalyseur est du bismuth, la température peut rester inférieure à environ 275°C. Selon un mode de réalisation préféré, on utilise un alliage d'étain et de bismuth (par exemple avec ∼10% de Bi) pour fabriquer des nanofils dopés n, ou encore un alliage d'étain et de gallium (par exemple avec 10% de Ga) pour fabriquer des nanofils dopés p. Le procédé est applicable sur de nombreux substrats de faible coût, tel que substrat de verre, de métal à bas coût, de polymère ou de feuille plastique. De plus, l'invention est applicable à différentes tailles de substrat et compatible avec les lignes de production actuelles de cellules solaires à base de silicium amorphe et silicium microcristallin.

La structure à jonction radiale de l'invention ne présente quasiment pas d'effet Staebler-Wronski. Du fait que l'épaisseur des couches de la jonction radiale est faible, l'effet Staebler-Wronski est limité à une valeur de saturation d'environ 4% au lieu de 20% dans une structure en couches minces de silicium amorphe.

Le procédé de l'invention pourrait être une étape clé pour permettre la fabrication de jonctions électroniques de structure radiale ayant une forte efficacité. De plus, le procédé de l'invention est simplifié comparé aux techniques antérieures, puisqu'il ne nécessite qu'un seul gaz dopant.

L'utilisation de catalyseurs métalliques tels que le bismuth ou un alliage de bismuth et d'étain pour catalyser la croissance de nanofils de silicium ne constitue pas un poison électronique pour le matériau semi-conducteur. Au contraire, l'or qui est généralement utilisé comme catalyseur dans la croissance ce nanofils de silicium, doit être entièrement retiré dans une chambre de traitement spécifique pour éviter toute contamination du silicium. Un autre avantage des catalyseurs métalliques utilisés est leur moindre coût comparé au coût de l'or.

L'invention permet avantageusement de fabriquer une jonction radiale de nanofils photovoltaïques dans une configuration de cellules solaires en couches minces avec une jonction p-n ou p-i-n. La fabrication et le dopage de nanofils peuvent être réalisés en une seule étape par un procédé de catalyse.

Le catalyseur métallique présente avantageusement un point de fusion à une température faible inférieure à 275°C dans le cas du Bi. L'invention permet l'utilisation de seulement un gaz dopant dans une seule chambre de dépôt de couches minces, ce qui permet de simplifier le procédé de fabrication. Le procédé de fabrication est aussi plus rapide ce qui permet de réduire le coût de l'ensemble du procédé de fabrication. L'invention permet de fabriquer des structures à jonction radiale ayant un rendement élevé pour une faible épaisseur de dépôt. L'invention s'applique notamment au procédé de fabrication de cellules solaires.

## Revendications

1. Procédé de production à basse température d'au moins une nanostructure semi-conductrice à jonction électronique radiale sur un substrat (1), ledit procédé comprenant les étapes suivantes :
a) formation d'agrégats métalliques en nanogouttes sur ledit substrat (2), lesdits agrégats métalliques dopant électroniquement un premier matériau semi-conducteur avec un premier type de dopage, ledit premier matériau semi-conducteur étant choisi parmi du silicium et du germanium et lesdits agrégats métalliques étant constitués de bismuth, de gallium ou d'un alliage d'étain et d'un matériau choisi parmi le bismuth et le gallium, le bismuth ou l'alliage de bismuth et d'étain produisant un dopage électronique de type n dans du silicium dans lequel le bismuth est le dopant de type n, respectivement le gallium ou l'alliage de gallium et d'étain produisant un dopage électronique de type p dans du silicium dans lequel le gallium est le dopant de type p ;
b) croissance en phase vapeur de nanofils semi-conducteurs dopés (2) en ledit premier matériau semi-conducteur sur ledit substrat (2) recouvert d'agrégats métalliques, ledit substrat (1) étant chauffé à une température supérieure ou égale à la température eutectique desdits agrégats métalliques, la croissance en phase vapeur de nanofils semi-conducteurs dopés (2) étant catalysée par lesdits agrégats métalliques en présence d'un ou plusieurs gaz précurseurs dudit premier matériau semi-conducteur, lesdits un ou plusieurs gaz précurseurs étant non dopants,
c) inactivation des agrégats métalliques résiduels,
d) dépôt chimique en phase vapeur en présence d'un ou plusieurs gaz précurseurs et d'un gaz dopant d'au moins une couche mince (4) d'un second matériau semi-conducteur sur lesdits nanofils semi-conducteurs dopés (2), ledit second matériau semi-conducteur étant choisi parmi du silicium et du germanium, ledit gaz dopant étant apte à doper électroniquement ledit second matériau semiconducteur avec un second type de dopage, et ladite au moins une couche mince (4) d'un second matériau semi-conducteur étant déposée de manière conforme sur lesdits nanofils semi-conducteurs dopés (1) pour former au moins une nariostructure à jonction électronique radiale entre ledit nanofil semi-conducteur dopé (2) avec un premier type de dopage et ladite au moins une couche mince dopée (4) avec un second type de dopage,
- lesdites a) étapes de formation d'agrégats métalliques, b) de croissance de nanofils semi-conducteurs dopés, c) d'inactivation des agrégats métalliques et d) de dépôt chimique en phase vapeur étant réalisées successivement dans une même enceinte de dépôt sous vide.

2. Procédé de production d'au moins une nanostructure semi-conductrice à jonction électronique radiale selon la revendication 1, comprenant une étape intermédiaire entre l'étape c) d'inactivation des agrégats métalliques résiduels et l'étape d) de dépôt chimique en phase vapeur d'au moins une couche mince d'un second matériau semi-conducteur dopé, ladite étape intermédiaire comprenant une étape de dépôt chimique en phase vapeur en présence d'un ou plusieurs gaz précurseurs d'une autre couche mince (3) d'un troisième matériau semi-conducteur intrinsèque de manière conforme sur lesdits nanofils semi-conducteurs dopés (2), ledit troisième matériau semi-conducteur étant choisi parmi du silicium et du germanium, lesdits nanofils semi-conducteurs dopés (2) étant dopés de type p et ladite au moins une couche mince (4) d'un second matériau semi-conducteur étant dopée n pour former des nanostructures semi-conductrices à jonction électronique radiale de type p-i-n, ou respectivement lesdits nanofils semi-conducteurs dopés (2) étant dopés de type n et ladite au moins une couche mince (4) d'un second matériau semi-conducteur étant dopée p pour former des nanostructures semi-conductrices à jonction électronique radiale de type n-i-p.

3. Procédé de production d'au moins une nanostructure semi-conductrice à jonction électronique radiale selon la revendication 1 ou 2, dans lequel l'étape c) d'inactivation des agrégats métalliques résiduels comprend une étape de diminution de la température jusqu'à une température inférieure à la température eutectique desdits agrégats métalliques et/ou une étape de gravure chimique en phase vapeur et/ou une étape d'application d'un plasma réducteur d'hydrogène.

4. Procédé de production d'au moins une nanostructure semi-conductrice à jonction électronique radiale selon l'une des revendications 1 à 3, dans lequel l'étape d) de dépôt chimique d'au moins une couche mince (4) d'un second matériau semi-conducteur dopé comprend une étape de dépôt chimique en phase vapeur, ou une étape de dépôt chimique en phase vapeur assisté par plasma, en présence d'un mélange de gaz comprenant un gaz précurseur du second matériau semi-conducteur et un gaz dopant.

5. Procédé de production d'au moins une nanostructure semi-conductrice à jonction électronique radiale selon la revendication 1 à 4, dans lequel ledit premier matériau semi-conducteur est du silicium cristallin dopé de type p et ledit second matériau semi-conducteur est du silicium amorphe dopé de type n, et/ou ledit troisième matériau semi-conducteur est du silicium amorphe intrinsèque.

6. Procédé de production d'au moins une nanostructure semi-conductrice à jonction électronique radiale selon l'une des revendications 2 à 5, dans lequel ladite couche mince (3) d'un troisième matériau semi-conducteur intrinsèque comporte du silicium amorphe, et en ce que ledit procédé comporte une étape supplémentaire après l'étape c) d'inactivation des agrégats métalliques résiduels et avant l'étape de dépôt de ladite couche mince (3) de silicium amorphe intrinsèque, ladite étape supplémentaire comprenant une étape de dépôt chimique en phase vapeur en présence d'un ou plusieurs gaz précurseurs d'une couche mince amorphe d'un matériau semi-conducteur ayant le même type de dopage que les nanofils semi-conducteurs dopés (2) de manière conforme sur lesdits nanofils semi-conducteurs dopés (2).

7. Procédé de production d'au moins une nanostructure semi-conductrice à jonction électronique radiale selon l'une des revendications 1 à 6, comprenant au moins une étape supplémentaire suivante après l'étape d) :
e) Dépôt d'au moins un autre empilement d'une pluralité de couches minces de matériau semi-conducteur, ledit au moins un autre empilement de couches minces étant déposé de manière conforme sur ladite au moins une nanostructures semi-conductrice à jonction électronique radiale et ladite pluralité de couches minces ayant un dopage respectif adapté pour former au moins une nanostructure semi-conductrice à double jonction électronique radiale.

8. Procédé .de production d'au moins une nanostructure semi-conductrice à jonction électronique radiale selon l'une des revendications 1 à 7, dans lequel la température du substrat pendant les étapes a) b) c) et d) reste inférieure à 400°C.

9. Procédé de production d'au moins une nanostructure semi-conductrice à jonction électronique radiale selon l'une des revendications 1 à 8, dans lequel le substrat est un substrat métallique non texture, en silicium cristallin ou polycristallin, en verre, en polymère, ou en matériau plastique.

10. Dispositif à jonction électronique radiale comprenant :
- un substrat (1) ;
- au moins un nanofil semi-conducteur dopé (2) en un premier matériau semi-conducteur dopé avec un premier type de dopage, ledit au moins un nanofil semi-conducteur dopé s'étendant à partir dudit substrat, dans lequel ledit premier matériau est choisi parmi du silicium et du germanium, et dans lequel le bismuth est le dopant de type n, respectivement dans lequel le gallium est le dopant de type p.
- au moins une couche mince (4) d'un second matériau semi-conducteur avec un second type de dopage, ladite au moins une couche mince (4) d'un second matériau semi-conducteur étant déposée de manière conforme sur ledit au moins un nanofil semi-conducteur dopé (2) pour former au moins une nanostructure semi-conductrice à jonction électronique radiale entre ledit nanofil semi-conducteur dopé (2) et ladite au moins une couche mince (4) d'un second matériau semi-conducteur dopé, ledit second matériau semi-conducteur étant choisi parmi du silicium et du germanium,

11. Dispositif à jonction électronique radiale selon la revendication 10 comprenant en outre une autre couche mince (3) d'un troisième matériau semi-conducteur intrinsèque déposée de manière conforme sur ledit au moins un nanofil semi-conducteur dopé (2) et en dessous ladite au moins une couche mince d'un second matériau semi-conducteur, ledit troisième matériau semi-conducteur étant choisi parmi du silicium et du germanium, ledit au moins un nanofil semiconducteur dopé (2) étant dopé de type p et ladite au moins une couche mince (4) d'un second matériau semi-conducteur étant dopée n pour former au moins une nanostructure semi-conductrice à jonction électronique radiale de type p-i-n, ou respectivement ledit au moins un nanofil semi-conducteur dopé (2) étant dopé de type n et ladite au moins une couche mince (4) d'un second matériau semi-conducteur étant dopée p pour former au moins une nanostructure semi-conductrice à jonction électronique radiale de type n-i-p.

12. Dispositif à jonction électronique radiale selon la revendication 10 ou la revendication 11, comprenant en outre au moins un autre empilement d'une pluralité de couches minces semi-conductrices, ledit au moins un autre empilement de couches minces étant déposé de manière conforme sur ladite au moins une nanostructure semi-conductrice à jonction électronique radiale et ladite pluralité de couches minces semi-conductrices ayant un dopage respectif adapté pour former au moins une nanostructure semi-conductrice à double jonction électronique radiale.

13. Dispositif à jonction électronique radiale selon l'une des revendications 10 à 12, dans laquelle ladite au moins une nanostructure semi-conductrice dopée comprend au moins un nanofil dopé (2) de silicium.

14. Cellule solaire comprenant une pluralité de nanostructures à jonction électronique radiale selon l'une des revendications 10 à 13.

## Patentansprüche

1. Verfahren zur Tieftemperaturherstellung von wenigstens einer Halbleiternanostruktur mit radialen elektronischen Übergängen auf einem Substrat (1), wobei das Verfahren die folgenden Schritte aufweist:
a) Bilden von metallischen Anhäufungen aus Nanotropfen auf dem Substrat (1), wobei die metallischen Anhäufungen elektronisch ein erstes Halbleitermaterial mit einem ersten Dotierungstyp dotieren, wobei das erste Halbleitermaterial unter Silizium und Germanium ausgewählt ist und die metallischen Anhäufungen aus Wismut, Gallium oder einer Legierung aus Zinn und einem unter Wismut und Gallium ausgewählten Material bestehen, wobei das Wismut oder die Legierung aus Wismut und Zinn ein elektronisches Dotieren vom n-Typ im Silizium erzeugt, wobei das Wismut das Dotiermittel vom n-Typ ist, bzw. wobei das Gallium oder die Legierung aus Gallium und Zinn ein elektronisches Dotieren vom p-Typ im Silizium erzeugt, wobei das Gallium das Dotiermittel vom p-Typ ist,
b) Aufwachsen in der Dampfphase von dotierten Halbleiter-Nanofäden (2) im ersten Halbleitermaterial auf dem mit metallischen Anhäufungen bedeckten Substrat (1), wobei das Substrat (1) auf eine Temperatur erhitzt wird, die höher oder gleich der eutektischen Temperatur der metallischen Anhäufungen ist, wobei das Aufwachsen in der Dampfphase der dotierten Halbleiter-Nanofäden (2) durch die metallischen Anhäufungen in Gegenwart eines oder mehrerer Vorläufergase des ersten Halbleitermaterials katalysiert wird, wobei das eine oder die mehreren Vorläufergase nicht dotierend sind,
c) Desaktivieren der restlichen metallischen Anhäufungen,
d) chemisches Abscheiden wenigstens einer dünnen Schicht (4) eines zweiten Halbleitermaterials in der Dampfphase in Gegenwart eines oder mehrerer Vorläufergase und eines dotierenden Gases auf den dotierten Halbleiter-Nanofaden (2), wobei das zweite Halbleitermaterial aus Silizium und Germanium ausgewählt ist, wobei das dotierende Gas geeignet ist, das zweite Halbleitermaterial elektronisch mit einem zweiten Dotiertyp zu dotieren, und wobei die wenigstens eine dünne Schicht (4) eines zweiten Halbleitermaterials in konformer Weise auf die dotierten Halbleiter-Nanofaden (2) aufgebracht werden, um wenigstens eine Nanostruktur mit radialen elektronischen Übergängen zwischen dem dotierten Nanofaden-Halbleiter (2) mit einem ersten Dotiertyp und der wenigstens einen dotierten dünnen Schicht (4) mit einem zweiten Dotiertyp zu bilden,
wobei die Schritte a) des Bildens metallischer Anhäufungen, b) des Aufwachsens von dotierten Halbleiter-Nanofaden, c) des Desaktivierens der metallischen Anhäufungen und d) des chemischen Abscheidens in der Dampfphase aufeinanderfolgend in ein und derselben Abscheidekammer unter Vakuum ausgerührt werden.

2. Verfahren zur Herstellung von wenigstens einer Halbleiternanostruktur mit radialen elektronischen Übergängen gemäß Anspruch 1, das einen Zwischenschritt zwischen dem Schritt c) des Desaktivierens der restlichen metallischen Anhäufungen und dem Schritt d) des chemischen Abscheidens wenigstens einer dünnen Schicht (4) eines zweiten Halbleitermaterials in der Dampfphase aufweist, wobei der Zwischenschritt einen Schritt des chemischen Abscheidens einer anderen dünnen Schicht (3) eines eigenen dritten Halbleitermaterials in der Dampfphase in Gegenwart eines oder mehrerer Vorläufergase in konformer Weise auf die dotierten Halbleiter-Nanofäden (2) aufweist, wobei das dritte Halbleitermaterial aus Silizium und Germanium ausgewählt ist, die dotierten Halbleiter-Nanofäden (2) vom p-Typ dotiert sind und die wenigstens eine dünne Schicht eines zweiten Halbleitermaterials (4) vom n-Typ dotiert ist, um Halbleiternanostrukturen mit radialen elektronischen Übergängen vom Typ p-i-n zu bilden, oder aber die dotierten Halbleiter-Nanofäden (2) vom n-Typ dotiert sind und die wenigstens eine dünne Schicht eines zweiten Halbleitermaterials (4) vom p-Typ dotiert ist, um Halbleiternanostrukturen mit radialen elektronischen Übergängen vom Typ n-i-p zu bilden.

3. Verfahren zur Herstellung von wenigstens einer Halbleiternanostruktur mit radialen elektronischen Übergängen gemäß Anspruch 1 oder 2, bei dem der Schritt c) des Desaktivierens der restlichen metallischen Anhäufungen einen Schritt des Reduzierens der Temperatur bis auf eine Temperatur unterhalb der eutektischen Temperatur der metallischen Anhäufungen und/oder einen Schritt der chemischen Gravur in der Dampfphase und/oder einen Schritt der Anwendung eines Wasserstoff reduzierenden Plasmas aufweist.

4. Verfahren zur Herstellung von wenigstens einer Halbleiternanostruktur mit radialen elektronischen Übergängen gemäß einem der Ansprüche 1 bis 3, bei dem der Schritt d) des chemischen Abscheidens wenigstens einer dünnen Schicht (4) eines dotierten zweiten Halbleitermaterials einen Schritt des chemischen Abscheidens in der Dampfphase oder einen Schritt des chemischen Abscheidens in der Dampfphase mit Unterstützung durch Plasma in Gegenwart eines ein Vorläufergas des zweiten Halbleitermaterials und ein dotierendes Gas aufweisenden Gasgemischs aufweist.

5. Verfahren zur Herstellung von wenigstens einer Halbleiternanostruktur mit radialen elektronischen Übergängen gemäß einem der Ansprüche 1 bis 4, bei dem das erste Halbleitermaterial p-dotiertes kristallines Silizium ist und das zweite Halbleitermaterial n-dotiertes amorphes Silizium ist und/oder das dritte Halbleitermaterial eigenes amorphes Silizium ist.

6. Verfahren zur Herstellung von wenigstens einer Halbleiternanostruktur mit radialen elektronischen Übergängen gemäß einem der Ansprüche 2 bis 5, bei dem die dünne Schicht (3) eines eigenen dritten Halbleitermaterials amorphes Silizium aufweist und das **dadurch gekennzeichnet ist, daß** das Verfahren einen zusätzlichen Schritt nach dem Schritt c) des Desaktivierens der restlichen metallischen Anhäufungen und vor dem Schritt des Abscheidens der dünnen Schicht (3) eines eigenen dritten, amorphes Silizium aufweisenden Halbleitermaterials aufweist, wobei der zusätzliche Schritt einen Schritt des chemischen Abscheidens in der Dampfphase in Gegenwart eines oder mehrerer Vorläufergase einer amorphen dünnen Schicht eines Halbleitermaterials vom gleichen Dotiertyp wie die dotierten Halbleiter-Nanofäden (2) in konformer Weise auf die dotierten Halbleiter-Nanofäden (2) aufweist.

7. Verfahren zur Herstellung von wenigstens einer Halbleiternanostruktur mit radialen elektronischen Übergängen gemäß einem der Ansprüche 1 bis 6, das nach dem Schritt d) wenigstens einen zusätzlichen folgenden Schritt aufweist:
e) Abscheiden wenigstens einer weiteren Aufschichtung einer Mehrzahl von dünnen Schichten eines Halbleitermaterials, wobei die wenigstens eine weitere Aufschichtung dünner Schichten in konformer Weise auf die wenigstens eine Halbleiternanostruktur mit radialen elektronischen Übergängen und die Mehrzahl dünner Schichten eine jeweilig geeignete Dotierung aufweisen, um wenigstens eine Halbleiternanostruktur mit doppelten radialen elektronischen Übergängen zu bilden.

8. Verfahren zur Herstellung von wenigstens einer Halbleiternanostruktur mit radialen elektronischen Übergängen gemäß einem der Ansprüche 1 bis 7, bei dem die Temperatur des Substrats während der Schritte a), b), c) und d) unter 400°C bleibt.

9. Verfahren zur Herstellung von wenigstens einer Halbleiternanostruktur mit radialen elektronischen Übergängen gemäß einem der Ansprüche 1 bis 8, bei dem das Substrat ein metallisches, nicht texturiertes Substrat aus kristallinem oder polykristallinem Silizium, aus Glas, aus einem Polymer oder aus Plastikmaterial ist.

10. Vorrichtung mit radialen elektronischen Übergängen mit:
- einem Substrat (1),
- wenigstens einem dotierten Halbleiter-Nanofaden (2) aus einem ersten, mit einem ersten Dotiertyp dotierten Halbleitermaterial, wobei sich der wenigstens eine dotierte Halbleiter-Nanofaden vom Substrat aus erstreckt, bei dem das erste Material aus Silizium und Germanium ausgewählt ist und bei dem Wismut das Dotiermittel vom n-Typ bzw. Gallium das Dotiermittel vom p-Typ ist,
- wenigstens einer dünnen Schicht (4) eines zweiten Halbleitermaterials mit einem zweiten Dotiertyp, wobei die wenigstens eine dünne Schicht (4) eines zweiten Halbleitermaterials in konformer Weise auf den wenigstens einen dotierten Halbleiter-Nanofaden aufgebracht ist, um wenigstens eine Halbleiternanostruktur mit radialen elektronischen Übergängen zwischen dem dotierten Halbleiter-Nanofaden (2) und der wenigstens einen dünnen Schicht (4) eines dotierten zweiten Halbleitermaterials zu bilden, wobei das zweite Halbleitermaterial aus Silizium und Germanium ausgewählt ist.

11. Vorrichtung mit radialen elektronischen Übergängen gemäß Anspruch 10, die außerdem eine andere dünne Schicht (3) eines eigenen, in konformer Weise auf den wenigstens einen dotierten Halbleiter-Nanofäden (2) und unter der wenigstens einen dünnen Schicht eines zweiten Halbleitermaterials aufgebrachten dritten Halbleitermaterials aufweist, wobei das dritte Halbleitermaterial aus Silizium und Germanium ausgewählt ist, der wenigstens eine dotierte Halbleiter-Nanofaden (2) vom p-Typ dotiert ist und die wenigstens eine dünne Schicht eines zweiten Halbleitermaterials (4) vom n-Typ dotiert ist, um wenigstens eine Halbleiternanostruktur mit radialen elektronischen Übergängen vom Typ p-i-n zu bilden, oder aber der wenigstens eine dotierte Halbleiter-Nanofaden (2) vom n-Typ dotiert ist und die wenigstens eine dünne Schicht eines zweiten Halbleitermaterials (4) vom p-Typ dotiert ist, um wenigstens eine Halbleiternanostruktur mit radialen elektronischen Übergängen vom Typ n-i-p zu bilden.

12. Vorrichtung mit radialen elektronischen Übergängen gemäß Anspruch 10 oder Anspruch 11, die außerdem eine weitere Aufschichtung einer Mehrzahl von dünnen Schichten eines Halbleitermaterials aufweist, wobei die wenigstens eine weitere Aufschichtung dünner Schichten in konformer Weise auf die wenigstens eine Halbleiternanostruktur mit radialen elektronischen Übergängen aufgebracht ist und die Mehrzahl dünner Halbleiterschichten eine jeweilig geeignete Dotierung aufweist, um wenigstens eine Halbleiternanostruktur mit doppelten radialen elektronischen Übergängen zu bilden.

13. Vorrichtung mit radialen elektronischen Übergängen gemäß einem der Ansprüche 10 bis 12, bei der die wenigstens eine dotierte Halbleiternanostruktur wenigstens einen dotierten Nanofaden (2) aus Silizium aufweist.

14. Solarzelle mit einer Mehrzahl von Nanostrukturen mit radialen elektronischen Übergängen gemäß einem der Ansprüche 10 bis 13.

## Claims

1. A method for the low-temperature production of at least one radial-electronic-junction semiconductor nanostructure on a substrate (1), said method comprising the following steps:
a) formation of nanodrops of metal aggregates on said substrate (2), said metal aggregates electronically doping a first semiconductor material with a first doping type, said first semiconductor material being chosen among silicon and germanium and said metal aggregates being consisted of bismuth, gallium or an alloy of tin and a material chosen among bismuth and gallium, bismuth or the bismuth and tin alloy producing a n type electronic doping in silicon wherein bismuth is the n type dopant, respectively gallium or the tin and gallium alloy producing a p type electronic doping in silicon wherein gallium is the p type dopant;
b) vapour-phase growth of doped semiconductor nanowires (2) in said first semiconductor material on said substrate (2) covered with metal aggregates, said substrate (1) being heated to a temperature higher than or equal to the eutectic temperature of said metal aggregates, the vapour-phase growth of doped semiconductor nanowires (2) being catalyzed by said metal aggregates in the presence of one or several precursor gases of said first semiconductor material, said one or several precursor gases being non-dopant gases,
c) inactivation of the residual metal aggregates,
d) chemical vapour deposition in the presence of one or several precursor gases and one dopant gas of at least one thin layer (4) of a second semiconductor material on said doped semiconductor nanowires (2), said second semiconductor material being chosen among silicon and germanium, said dopant gas being capable of electronically doping said second semiconductor material with a second doping type, and said at least one thin layer (4) of a second semiconductor material being conformally deposited on said doped semiconductor nanowires (1) to form at least one radial-electronic-junction nanostructure between said semiconductor nanowires (2) doped with a first doping type and said at least one thin layer (4) doped with a second doping type,
- said steps of a) formation of metal aggregates, b) growth of doped semiconductor nanowires, c) inactivation of metal aggregates and d) chemical vapour deposition being performed successively in a same vacuum deposition chamber.

2. The method for the production of a least one radial-electronic-junction semiconductor nanostructure according to claim 1, comprising an intermediate step between step c) of inactivation of the residual metal aggregates and step d) of chemical vapour deposition of at least one thin layer of a second doped semiconductor material, said intermediate step comprising a step of chemical vapour deposition in the presence of one or several precursor gases of another thin layer (3) of a third intrinsic semiconductor material, conformally on said doped semiconductor nanowires (2), said third semiconductor material being chosen among silicon and germanium, said doped semiconductor nanowires (2) being p doped and said at least one thin layer (4) of a second semiconductor material being n doped to form p-i-n radial-electronic-junction semiconductor nanostructures, or respectively said doped semiconductor nanowires (2) being n doped and said at least one thin layer (4) of a second semiconductor material being p doped to form n-i-p radial-electronic-junction semiconductor nanostructures.

3. The method for the production of a least one radial-electronic-junction semiconductor nanostructure according to claim 1 or 2, wherein step c) of inactivation of the residual metal aggregates comprises a step of reduction of the temperature down to a temperature lower than the eutectic temperature of said metal aggregates and/or a step of chemical vapour etching and/or a step of application of a hydrogen-reducing plasma.

4. The method for the production of a least one radial-electronic-junction semiconductor nanostructure according to one of claims 1 to 3, wherein step d) of chemical deposition of at least one thin layer (4) of a second doped semiconductor material comprises a step of chemical vapour deposition or a step of plasma-enhanced chemical vapour deposition, in the presence of a gas mixture comprising a precursor gas of the second semiconductor material and a dopant gas.

5. The method for the production of a least one radial-electronic-junction semiconductor nanostructure according to claim 1 to 4, wherein said first semiconductor material is p doped crystalline silicon and said second semiconductor material is n doped amorphous silicon, and/or said third semiconductor material is intrinsic amorphous silicon.

6. The method for the production of a least one radial-electronic-junction semiconductor nanostructure according to one of claims 2 to 5, wherein said thin layer (3) of a third intrinsic semiconductor material includes amorphous silicon, and in that said method includes an additional step after step c) of inactivation of the residual metal aggregates and before the step of deposition of said thin layer (3) of intrinsic amorphous silicon, said additional step comprising a step of chemical vapour deposition in the presence of one or several precursor gases of an amorphous thin layer of a semiconductor material having the same doping type as the doped semiconductor nanowires (2), conformally on said doped semiconductor nanowires (2).

7. The method for the production of a least one radial-electronic-junction semiconductor nanostructure according to one of claims 1 to 6, comprising at least one following additional step after step d):
e) deposition of at least one other stack of a plurality of thin layers of semiconductor material, said at least one other stack of thin layers being deposited conformally on said at least one radial-electronic-junction semiconductor nanostructure and said plurality of thin layers having a respective doping adapted to form at least one dauble-radial-electronic-junction semiconductor nanostructure.

8. The method for the production of a least one radial-electronic-junction semiconductor nanostructure according to one of claims 1 to 7, wherein the temperature of the substrate during steps a) b) c) and d) remains lower than 400°C.

9. The method for the production of a least one radial-electronic-junction semiconductor nanostructure according to one of claims 1 to 8, wherein the substrate is a non-textured metal substrate, crystalline or polycrystalline silicon, glass, polymer or plastic material.

10. A radial-electronic-junction device comprising:
- a substrate (1);
- at least one doped semiconductor nanowire (2) made of a first semiconductor material doped with a first doping type, said at least one doped semiconductor nanowire extending from said substrate, wherein said first semiconductor material is chosen among silicon and germanium, and wherein bismuth is the n type dopant, respectively wherein gallium is the p type dopant;
- at least one thin layer (4) of a second semiconductor material with a second doping type, said at least one thin layer (4) of a second semiconductor material being deposited conformally on said at least one doped semiconductor nanowire (2) to form at least one radial-electronic-junction semiconductor nanostructure between said doped semiconductor nanowire (2) and said at least one thin layer (4) of a second doped semiconductor material, said second semiconductor material being chosen among silicon and germanium.

11. The radial-electronic-junction device according to claim 10, further comprising another thin layer (3) of a third intrinsic semiconductor material deposited conformally on said at least one doped semiconductor nanowire (2) and under said at least one thin layer of a second semiconductor material, said third semiconductor material being chosen among silicon and germanium, said at least one doped semiconductor nanowire (2) being p doped and said at least one thin layer (4) of a second semiconductor material being n doped to form at least one p-i-n radial-electronic-junction semiconductor nanostructure, or respectively said at least one doped semiconductor nanowire (2) being n doped and said at least one thin layer (4) of a second semiconductor material being p doped to form at least one n-i-p radial-electronic-junction semiconductor nanostructure.

12. The radial-electronic-junction device according to claim 10 or claim 11, further comprising at least one other stack of a plurality of semiconductor thin layers, said at least one other stack of thin layers being deposited conformally on said at least one radial-electronic-junction semiconductor nanostructure and said plurality of semiconductor thin layers having a respective doping adapted to form at least one double-radial-electronic-junction semiconductor nanostructure.

13. The radial-electronic-junction device according to one of claims 10 to 12, wherein said at least one doped semiconductor nanostructure comprises at least one silicon doped nanowire (2).

14. A solar cell comprising a plurality of radial-electronic-junction nanostructures according to one of claims 10 to 13.
